# EUROPÄISCHE PATENTSCHRIFT

(11) **EP 0 438 634 B1**
(45) Veröffentlichungstag und Bekanntmachung des Hinweises auf die Patenterteilung: **17.01.1996**
(21) Anmeldenummer: 90115980.6
(22) Anmeldetag: 21.08.1990
(51) Int. Cl.: H03K 17/955, B60S 1/08, G01R 27/26

(54) **Auswerteschaltung für einen kapazitiven Sensor**
Evaluation circuit for a capacitive sensor
Circuit d'évaluation pour capteur capacitif

(30) Priorität: 23.01.1990 DE 4001814
(43) Veröffentlichungstag der Anmeldung: 31.07.1991
(73) Patentinhaber: VDO Adolf Schindling AG, D-60487 Frankfurt (DE)
(72) Erfinder: Wallrafen, Werner, D-6231 Sulzbach/Ts. (DE)
(74) Vertreter: Klein, Thomas, Dipl.-Ing. (FH)

(56) Entgegenhaltungen:
- EP-A- 0 088 561
- EP-A- 0 175 362
- EP-A- 0 196 912
- US-A- 3 774 237
- US-A- 4 748 400

## Beschreibung

Die Erfindung betrifft eine Anordnung mit einem kapazitiven Sensor und einer Auswerteschaltung, wobei der kapazitive Sensor und ein Kondensator einen kapazitiven Spannungsteiler bilden, dessen Endanschlüssen gegenphasige Wechselspannungen gleicher Frequenz zugeführt Werden, daß der Verbindungspunkt zwischen dem Kondensator und dem kapazitiven Sensor gemeinsam mit dem Abgriff einer Spannungsquelle mit einem Synchrondemodulator verbunden ist, der zwei steuerbare Schalter aufweist, welchen mindestens eine Phase der Wechselspannung zugeführt wird.

Zur Erzeugung elektrischer Signale in Abhängigkeit von verschiedenen physikalischen Größen sind kapazitive Sensoren bekannt, bei welchen die Kapazität eines Kondensators von der jeweiligen physikalischen Größe abhängt. Häufig sind dabei die Kapazitätswerte im Bereich von 1 pF bis 10 Pf und somit schwierig auszuwerten. In denjenigen Fällen, in denen sich die Kapazitäten zweier Kondensatoren gegenläufig verändern, sind zwar einfachere Schaltungen bekanntgeworden, jedoch ist die Anordnung sogenannter Differentialkondensatoren nicht immer möglich.

Aus EP 0 175 362 A2 ist ein kapazititiver Sensor zur Steuerung eines Scheibenwischers bekannt, bei welchem die feuchtigkeitsabhängige Kapazität Teil einer Oszillatorschaltung ist. Wegen des geringen Kapazitätswertes schwingen derartige Schaltungen jedoch nur mit sehr hoher Frequenz. Dieses hat wiederum eine Störanfälligkeit gegenüber Einstrahlungen und Verluste in der Scheibe zu Folge.

Aus der EP-A-0196912 ist eine Anordnung mit einem kapazitiven Sensor und einer Auswerteschaltung bekannt, bei der der Sensor mit einer weiteren Kapazität einen Spannungsteiler bildet, dessen Endanschlüsse mit gegenphasigen Rechtecksignalen gleicher Frequenz beaufschlagt werden, wobei der Verbindungspunkt einem aus zwei Operationsvertärkern und zwei Schaltern bestehenden Synchrondemodulator zugeführt wird, der seinerseits mit einem der gegenphasigen Rechtecksignale getaktet wird und dessen Ausgangssignal das ausgewertete Signal liefert. Außerdem ist der Verbindungspunkt des Spannungsteilers an eine Hilfsspannungsquelle angeschossen.

Der vorliegenden Erfindung liegt die Aufgabe zugrunde, kleine Kapazitätswerte in elektrische Signale umzuwandeln, insbesondere eine Auswerteschaltung für einen kapazitiven Regensensor für Fahrzeuge anzugeben, die mit möglichst geringem Aufwand realisierbar ist und zuverlässig arbeitet.

Die erfindungsgemäße Auswerteschaltung ist dadurch gekennzeichnet, daß der Verbindungspunkt zwischen dem Kondensator und dem kapazitiven Sensor gemeinsam mit dem Abgriff der einen hohen Innenwiderstand aufweisenden Spannungsquelle mit dem Eingang eines Impedanzwandlers verbunden ist, und daß der Ausgang des Impedanzwandlers an die beiden steuerbaren Schalter des Synchrondemodulators führt, wobei den Schaltern als Steuerspannungen die gegenphasigen Wechselspannungen zuführbar sind, in dem der Eingang des einen steuerbaren Schalters mit der nichtinvertierten Ausgangsspannung des Impedanzwandlers und der Eingang des anderen steuerbaren Schalters mit der durch einen Inverter invertierten Ausgangsspannung des Impedanzwandlers beaufschlagbar ist.

Die erfindungsgemäße Auswerteschaltung bietet zusätzlich die Möglichkeit, einen weiteren Elektrodenanschluß des Sensorkondensators mit dem Ausgang des Impedanzwandlers zu verbinden. Dadurch ist eine Verringerung des Einflusses von weiteren Kapazitäten im Sensor möglich, welche die an sich bereits niedrige relative Änderung der Sensorkapazität noch verringern würden.

Die erfindungsgemäße Auswerteschaltung hat den Vorteil, daß sie gegenüber kleinen Kapazitätsänderungen empfindlich, jedoch gegenüber Störsignalen unempfindlich ist und daß sich die nicht vernachlässigbare Eingangskapazität und Eingangsruheströme des Verstärkers nur geringer als bei bekannten Schaltungen auswirken. Außerdem wirken sich. Drifterscheinungen, beispielsweise temperaturbedingte Änderungen, weniger aus. Darüberhinaus sind Störsignaleinkoppelungen des hochempfindlichen Abgriffs des kapazitiven Spannungsteilers durch eine synchrone Demodulation weitgehend vollständig unterdrückt unter der Voraussetzung, daß die Störsignale nicht mit der angesteuerten Wechselspannung korrelieren. Die erfindungsgemäße Auswerteschaltung eignet sich besonders für Regensensoren an Kraftfahrzeugen zur automatischen Steuerung von Scheibenwischern. Es sind jedoch auch andere Anwendungen der Auswerteschaltung möglich.

Eine weitere Unterdrückung von Störungen ist durch eine Weiterbildung der Erfindung möglich, die darin besteht, daß zwischen dem Impedanzwandler und dem Synchrondemodulator ein Bandpaßfilter angeordnet ist.

Eine andere Weiterbildung besteht darin, daß die gegenphasigen Wechselspannungen rechteckförmig sind. Dadurch wird eine Restwelligkeit der Ausgangsspannung der erfindungsgemäßen Auswerteschaltung praktisch vermieden.

Eine vorteilhafte Ausgestaltung der erfindungsgemäßen Auswerteschaltung besteht darin, daß als Synchrondemodulator zwei steuerbare Schalter vorgesehen sind, denen als Steuerspannungen die gegenphasigen Wechselspannungssignale zuführbar sind und daß der Eingang des einen steuerbaren Schalters mit der nicht invertierten Ausgangsspannung des Impedanzwandlers bzw. des Bandpaßfilters und der Eingang des anderen steuerbaren Schalters mit der invertierten Ausgangsspannung beaufschlagbar ist. Je nach Phase wird demzufolge mit +1 oder -1 multipliziert.

Zur weiteren Glättung der Ausgangsspannung kann vorgesehen sein, daß dem Synchrondemodulator ein Tiefpaßfilter nachgeschaltet ist.

Die Erfindung läßt zahlreiche Ausführungsformen zu. Eine davon ist schematisch in der Zeichnung anhand mehrerer Figuren dargestellt und nachfolgend beschrieben. Es zeigt:
- Fig. 1: ein Blockschaltbild eines Ausführungsbeispiels und
- Fig. 2: ein Schaltbild mit integrierten Bauteilen als Ausführungsbeispiel.

Gleiche Teile sind in den Figuren mit gleichen Bezugszeichen versehen.

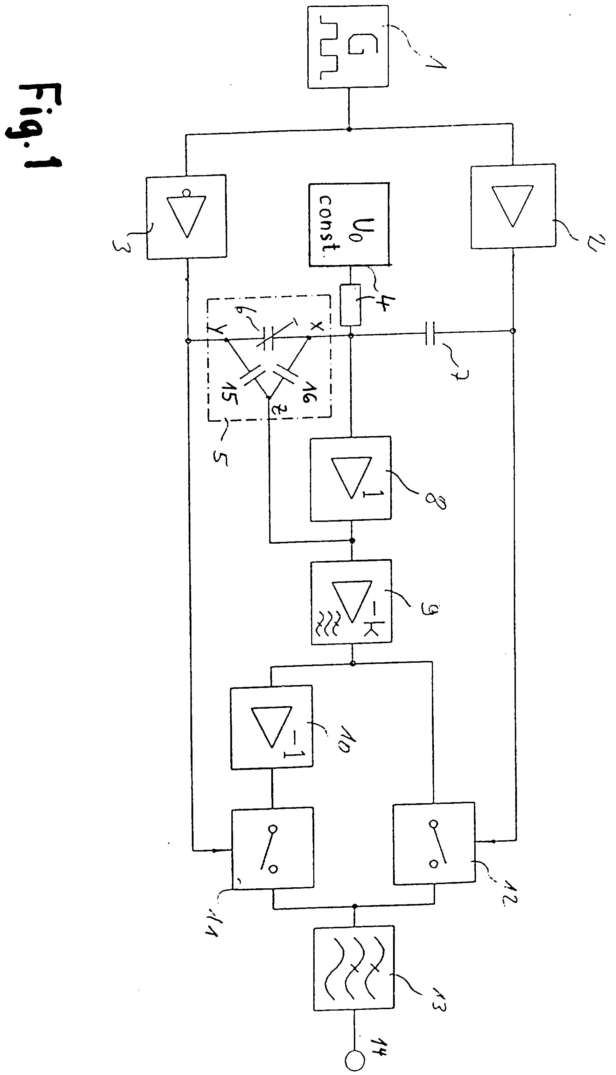

Bei der Auswerteschaltung nach Fig. 1 ist ein Generator 1 vorgesehen, der eine rechteckförmige Wechselspannung erzeugt, die über zwei Treiber 2, 3 geleitet und im Treiber 3 invertiert wird. Die gegenphasigen Wechselspannungen gelangen vom Ausgang der Treiber 2, 3 zu einem kapazitiven Spannungsteiler.

Der kapazitive Spannungsteiler besteht aus einem Kondensator 6, der Teil eines Feuchtesensors 5 ist und dessen Kapazität von der Feuchtigkeitsmenge auf der Windschutzscheibe abhängt, und einem festen Kondensator 7. Die Kapazität des Kondensators 7 wird vorzugsweise innerhalb des Variationsbereichs der Kapazität des Kondensators 6 gewählt. Die Anzapfungen beider Spannungsteiler sind mit dem Eingang eines Impedanzwandlers 8 verbunden, der eine hohe Eingangsimpedanz und einen Verstärkungsgrad von 1 aufweist.

Die Spannungsquelle 4 mit einem vorzugsweise höheren Innenwiderstand als die Impedanz des kapazitiven Spannungsteilers stellt einen definierten Arbeitspunkt ein. Der Ausgang des Impedanzwandlers 8 ist mit einem Anschluß Z des Sensors 5 verbunden, von dem jeweils ein Kondensator 15, 16 zu den Anschlüssen X, Y des Sensors 5 führt.

An den Impedanzwandler 8 schließt sich ferner ein invertierender Verstärker 9 mit Bandpaßcharakteristik an, dessen Ausgang einerseits über einen Invertierer 10 mit einem ersten steuerbaren Schalter 11 und andererseits direkt mit einem zweiten steuerbaren Schalter 12 verbunden ist. Die steuerbaren Schalter 11, 12 werden mit den gegenphasigen Wechselspannungen synchron angesteuert und sind jeweils während einer Halbperiode der Wechselspannungen leitend. Die Ausgänge der steuerbaren Schalter 11, 12 sind über ein Tiefpaßfilter 13 mit dem Ausgang 14 der Auswerteschaltung verbunden.

Sind die Kapazitätswerte der Kondensatoren 6, 7 gleich groß, so beträgt die Eingangsspannung des Impedanzwandlers 8 und damit auch die Ausgangsspannung wechselspannungsmäßig 0V und gleichspannungsmäßig U₀. Je nach Feuchtigkeitsmenge kann die Kapazität des Kondensators 6 kleiner oder größer als diejenige des Kondensators 7 sein. Dann ergibt sich am Ausgang des Impedanzwandlers 8 eine überlagerte rechteckförmige Wechselspannung, die bezüglich ihrer Amplitude und ihrer Phasenlage von der Feuchtigkeitsmenge abhängt. Der Wechselspannungsanteil wird in dem Verstärker 9 verstärkt und gleichzeitig von Störungen, welche andere Frequenzen als die Frequenz der Wechselspannung enthalten, befreit.

Der Invertierer 10 und die steuerbaren elektronischen Schalter 11, 12 stellen einen Synchrondemodulator dar, der die Ausgangsspannung des Verstärkers 9 phasenrichtig demoduliert. Mit dem Tiefpaßfilter 13 wird eine Restwelligkeit beseitigt, die ohnehin umso kleiner ist, als durch eine weitgehende Frequenzunabhängigkeit des kapazitiven Spannungsteilers die Rechteckform der Wechselspannung am Ausgang des Verstärkers 9 erhalten bleibt.

Am Ausgang 14 der Auswerteschaltung nach Fig. 1 steht dann eine Gleichspannung zur Verfügung, die proportional zur Kapazität des Sensorkondensators 6 ist. Durch die Rückführung der Ausgangsspannung des Impedanzwandlers 8 zum Anschluß Z des Sensors 5 ist eine Verringerung des Einflusses von weiteren Kapazitäten im Sensor möglich, welche die an sich bereits niedrige relative Änderung der Sensorkapazität noch verringern würden. Durch die Bandpaßcharakteristik des Verstärkers 9 wird unter anderem der Gleichspannungsanteil unterdrückt, so daß sich Drifterscheinungen, wie beispielsweise Temperaturabhängigkeiten oder sich zeitlich verändernde Ruheströme, nicht im Meßergebnis bemerkbar machen.

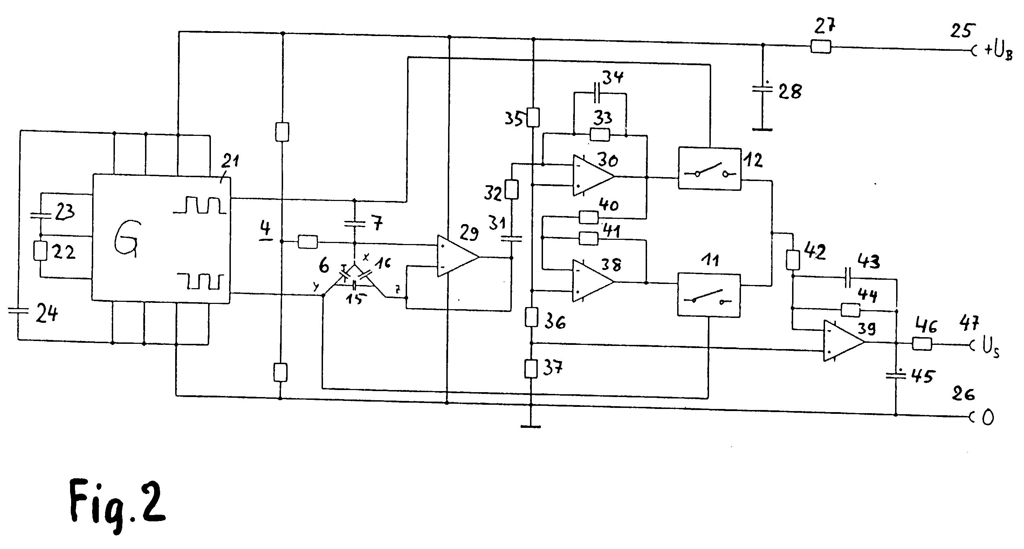

Fig. 2 zeigt eine praktisch ausgeführte Auswerteschaltung, deren Funktion der Auswerteschaltung nach Fig. 1 entspricht. Als Generator für eine rechteckförmige Wechselspannung wird ein integrierter Baustein 21 verwendet. Ein Widerstand 22 und ein Kondensator 23 dienen dabei als frequenzbestimmendes Glied. Ferner ist ein Kondensator 24 zur Vermeidung von Störsignalen vorgesehen. Der Baustein 21 erhält wie die übrigen Teile der Schaltungsanordnung über Anschlüsse 25, 26 und über ein Siebglied 27, 28 eine Betriebsspannung von beispielsweise U_{B} = 5V.

Der ohmsche Spannungsteiler 4 dient als hochohmige Spannungsquelle mit geringer parasitärer Streukapazität und der kapazitive Spannungsteiler 6, 7 sowie der Sensor 5 sind bereits im Zusammenhang mit Fig. 1 erläutert worden. Als Impedanzwandler dient ein Operationsverstärker 29, dessen Ausgang mit dem invertierenden Eingang verbunden ist, so daß sich der Verstärkungsfaktor von 1 ergibt.

Als Verstärker und Bandpaßfilter 9 (Fig. 1) dient bei der Schaltungsanordnung nach Fig. 2 ein weiterer Operationsverstärker 30, dessen invertierendem Eingang die Ausgangsspannung des Operationsverstärkers 29 über einen Kondensator 31 und einen Widerstand 32 zugeführt ist, wobei der Kondensator 31 zur Begrenzung des Bandes in Richtung auf tiefere Frequenzen dient. Im Gegenkopplungskreis liegt ein Widerstand 33. Die obere Bandgrenze wird mit Hilfe einer Gegenkopplungskapazität festgelegt, die aus einem Kondensator 34 besteht. Der nichtinvertierende Eingang des Operationsverstärkers 30 erhält eine konstante Vorspannung über einen Spannungsteiler 35, 36, 37, der auch zur Vorspannungserzeugung weiterer Operationsverstärker 38, 39 dient.

Der Operationsverstärker 38 dient als Invertierer mit einem Verstärkungsfaktor von 1 mit einem Gegenkopplungswiderstand 41 und ist über einen Widerstand 40 mit dem Ausgang des Operationsverstärkers 30 verbunden. Die steuerbaren Schalter 11, 12 sind in an sich bekannter Weise durch integrierte Bausteine realisiert.

Die Ausgänge der steuerbaren Schalter sind über einen Widerstand 42 mit dem invertierenden Eingang des Operationsverstärkers 39 verbunden, der ein Tiefpaßfilter darstellt und dazu mit einer frequenzabhängigen Gegenkopplung 43, 44 versehen ist. Außerdem ist der Ausgang des Operationsverstärkers 39 über einen Kondensator 45 mit Massepotential verbunden. Schließlich wird die Ausgangsspannung des Operationsverstärkers 39 über einen Schutzwiderstand 46 an den Ausgang 47 der Schaltungsanordnung geleitet.

## Patentansprüche

1. Anordnung mit einem kapazitiven Sensor und einer Auswerteschaltung, wobei der kapazitive Sensor (6) und ein Kondensator (7) einen kapazitiven Spannungsteiler bilden, dessen Endanschlüssen gegenphasige Wechselspannungen gleicher Frequenz zugerführt werden, daß der Verbindungspunkt zwischen dem Kondensator und dem Kapazitiven Sensor gemeinsam mit dem Abgriff einer Spannungsquelle (4) mit einem synchrondemodulator verbunden ist, der zwei steuerbare Schalter (11,12) aufweist, welchen mindestens eine Phase der Wechselspannung zugeführt wird, dadurch gekennzeichnet, daß der Verbindungspunkt zwischen dem Kondensator (7) und dem kapazitiven Sensor (6) gemeinsam mit dem Abgriff der einen hohen Innenwiderstand aufweisenden Spannungsquelle (4) mit dem Eingang eines Impedanzwandlers (8) verbunden ist, daß der Ausgang des Impedanzwandlers (8) an die beiden steuerbaren Schalter (11,12) des Synchrondemodulators führt, wobei den Schaltern (11,12) als Steuerspannungen die gegenphasigen Wechselspannungen zugeführt werden, und daß der Eingang des einen steuerbaren Schalters (12) mit der nichtinvertierten Ausgangsspannung des Impedanzwandlers (8) und der Eingang des anderen steuerbaren Schalters (11) mit der durch einen Inverter (10) invertierten Ausgangsspannung des Impedanzwandlers (8) beaufschlagt ist.

2. Auswerteschaltung nach Anspruch 1, dadurch gekennzeichnet, daß der Ausgang des Impedanzwandlers (8) ferner über einen weiteren Kondensator (16) mit einem von der Wechselspannungsquelle abgewandten Anschluß (X) des kapazitiven Sensors (6) verbunden ist.

3. Auswerteschaltung nach einem der Ansprüche 1 oder 2, dadurch gekennzeichnet, daß zwischen dem Impedanzwandler (8) und dem Synchrondemodulator (10, 11, 12) ein Bandpaßfilter (9) angeordnet ist.

4. Auswerteschaltung nach einem der vorhergehenden Ansprüche, dadurch gekennzeichnet, daß die gegenphasigen Wechselspannungen rechteckförmig sind.

5. Auswerteschaltung nach Anspruch 4, dadurch gekennzeichnet, daß ein Spannungsteiler (4) den Abgriff des kapazitiven Spannungsteilers (6,7) hochohmig vorspannt.

6. Auswerteschaltung nach einem der vorhergehenden Ansprüche, dadurch gekennzeichnet, daß dem Synchrondemodulator (10, 11, 12) ein Tiefpaßfilter (13) nachgeschaltet ist.

## Claims

1. An arrangement having a capacitive sensor and an evaluation circuit, wherein the capacitive sensor (6) and a capacitor (7) form a capacitive static balancer, to the end connections of which AC voltages of the same frequency are fed in opposition of phase, that the connection point between the capacitor and the capacitive sensor is connected jointly with the tap of a voltage source (4) to a synchronous demodulator which has two controllable switches (11, 12) to which at least one phase of the AC voltage is fed, characterised in that the connection point between the capacitor (7) and the capacitive sensor (6) is connected, jointly with the tap of the voltage source (4), which has a high internal resistance, to the input of an impedance converter (8), that the output of the impedance converter (8) leads to the two controllable switches (11, 12) of the synchronous demodulator, wherein the AC voltages in opposition of phase are fed as control voltages to the switches (11, 12), and that the input of one controllable switch (12) is acted upon by the non-inverted output voltage of the impedance converter (8) and the input of the other controllable switch (11) is acted upon by the output voltage of the impedance converter (8) which is inverted by an inverter (10).

2. An evaluation circuit according to claim 1, characterised in that the output of the impedance converter (8) is also connected via a further capacitor (16) to a connection (X) of the capacitive sensor (6), which connection is removed from the AC voltage source.

3. An evaluation circuit according to either one of claims 1 or 2, characterised in that a band-pass filter (9) is disposed between the impedance converter (8) and the synchronous demodulator (10, 11, 12).

4. An evaluation circuit according to any one of the preceding claims, characterised in that the AC voltages in opposition of phase are of square wave form.

5. An evaluation circuit according to claim 4, characterised in that a static balancer (4) applies a high impedance bias to the tap of the capacitive static balancer (6, 7).

6. An evaluation circuit according to any one of the preceding claims, characterised in that a low-pass filter (13) is connected downstream of the synchronous demodulator (10, 11, 12).

## Revendications

1. Agencement comprenant un capteur capacitif et un circuit d'interprétation, le capteur capacitif (6) et un condensateur (7) formant un diviseur capacitif de tension aux raccords extrêmes duquel sont appliquées des tensions alternatives de même fréquence, en opposition de phase, le point de jonction entre le condensateur et le capteur capacitif étant relié, conjointement à la prise d'une source de tension (4), à un démodulateur synchrone muni de deux interrupteurs commandables (11, 12) auxquels est appliquée au moins une phase de la tension alternative, caractérisé par le fait que le point de jonction entre le condensateur (7) et le capteur capacitif (6) est relié, conjointement à la prise de la source de tension (4) présentant une forte résistance intérieure, à l'entrée d'un convertisseur d'impédance (8) ; par le fait que la sortie du convertisseur d'impédance (8) mène aux deux interrupteurs commandables (11, 12) du démodulateur synchrone, les tensions alternatives en opposition de phase étant appliquées aux interrupteurs (11, 12) en tant que tensions de commande ; et par le fait que l'entrée de l'un (12) des interrupteurs commandables est sollicitée par la tension de sortie non inversée du convertisseur d'impédance (8), et l'entrée de l'autre interrupteur commandable (11) est sollicitée par la tension de sortie dudit convertisseur d'impédance (8) qui est inversée par l'intermédiaire d'un inverseur (10).

2. Circuit d'interprétation selon la revendication 1, caractérisé par le fait que la sortie du convertisseur d'impédance (8) est en outre connectée, par l'intermédiaire d'un condensateur supplémentaire (16), à un raccord (X) du capteur capacitif (6) qui est tourné à l'opposé de la source de tension alternative.

3. Circuit d'interprétation selon l'une des revendications 1 ou 2, caractérisé par le fait qu'un filtre passe-bande (9) est branché entre le convertisseur d'impédance (8) et le démodulateur synchrone (10, 11, 12).

4. Circuit d'interprétation selon l'une des revendications précédentes, caractérisé par le fait que les tensions alternatives en opposition de phase sont de forme rectangulaire.

5. Circuit d'interprétation selon la revendication 4, caractérisé par le fait qu'un diviseur de tension (4) impose une contrainte préalable à forte valeur ohmique à la prise du diviseur capacitif de tension (6, 7).

6. Circuit d'interprétation selon l'une des revendications précédentes, caractérisé par le fait qu'un filtre passe-bas (13) est branché en aval du démodulateur synchrone (10, 11, 12).
